Europäisches Patentamt

European Patent Office

Office européen des brevets

(19)

(11) Publication number: **0 023 791**
**B1**

# EUROPEAN PATENT SPECIFICATION

(45) Date of publication of patent specification: **27.07.83**

(51) Int. Cl.³: **H 01 L 27/08** //H03K13/02

(21) Application number: **80302470.2**

(22) Date of filing: **21.07.80**

(54) **CMOS semiconductor device.**

(30) Priority: **24.07.79 JP 93992/79**

(43) Date of publication of application:
**11.02.81 Bulletin 81/6**

(45) Publication of the grant of the patent:
**27.07.83 Bulletin 83/30**

(84) Designated Contracting States:
**DE FR GB**

(56) References cited:
**GB - A - 1 542 481**
**US - A - 3 955 210**

**ELECTRONIC DESIGN, vol. 26, no. 4, 15th
February 1978, pages 26—32 Rochelle Park
"Analog chips are becoming systems: New LSI
merges analog and digital" Page 26, right figure**

(73) Proprietor: **FUJITSU LIMITED**
**1015, Kamikodanaka Nakahara-ku
Kawasaki-shi Kanagawa 211 (JP)**

(72) Inventor: **Ito, Akihiko**
**3780 Suge
Tama-ku, Kawasaki-shi Kanagawa 214 (JP)**
Inventor: **Saito, Tadahiro**
**532-4 Miyauchi
Nakahara-ku, Kawasaki-shi Kanagawa 211 (JP)**

(74) Representative: **Rackham, Stephen Neil et al,
GILL JENNINGS & EVERY 53-64 Chancery Lane
London WC2A 1HN (GB)**

## CMOS semiconductor device

The present invention relates to a semiconductor device, and more particularly relates to a CMOS (Complementary Metal Oxide Semiconductor) device.

Generally, CMOS elements forming a digital circuit and CMOS elements forming an analogue circuit are formed on different silicon substrates or chips and thus are electrically and physically independent from each other. However, in recent years, CMOS elements forming both digital and analogue circuits have been formed on the same, single silicon chip, to increase their packing density. For example, a coding and decoding apparatus, a so-called CODEC (coder and decoder), usually includes both digital and analogue CMOS devices and is formed on a single silicon chip. In such a digital and analogue CMOS device, it is a well known defect that undesired electric noise signals are induced in the analogue CMOS elements. The electric noise signals are created due to the occurrence of a sharp rising edge or a sharp falling edge of each rectangular pulse signal generated in the digital CMOS elements. In the past, the digital CMOS elements and the analogue CMOS elements have not been arranged randomly on the same silicon chip, but have been arranged in different areas to decrease the induction of electric noise signals in the analogue CMOS elements. However, it is very difficult to suppress the induction of the electric noise signals in the analogue elements.

In accordance with this invention a semiconductor device comprising at least one digital CMOS (Complementary Metal Oxide Semiconductor) element having a source region and a drain region both formed in a bulk, and at least one analogue CMOS element having a source region and a drain region both formed in the bulk, the digital CMOS element having a diffusion region adjacent it and the analogue CMOS element having a diffusion region adjacent it, the diffusion regions also being formed in the bulk and being connected to power supply terminals which are also connected to the source regions of the corresponding elements is characterised in that the device includes at least one first conductor and second conductor, which are physically independent of each other, the first conductor being connected between the power supply terminal and one of the source regions, and the second conductor being connected between the power supply terminal and the diffusion region of the corresponding element.

This provides a considerable improvement because the diffusion regions adjacent the source in the analogue devices pick up the noise signals and when these are directly connected to the source region the noise has a direct effect on the adjacent analogue device. Equally, the diffusion region adjacent the source in a digital device can also act as a pick up for noise signals and transfer them to the source of the adjacent digital CMOS device. By using separate and physically independent conductors and not directly connecting the source and diffusion regions these problems are overcome. In practice, the capacity of the power supply terminal and the conductor is sufficient to decouple the source region from the diffusion region when they are only connected via their common power supply terminal.

A particular example of a semiconductor device in accordance with this invention will now be described and contrasted with prior devices with reference to the accompanying drawings; in which:—

Figure 1 is a cross-section of part of a prior CMOS device;

Figure 2A is a plan of the P-channel transistor $Q_{p2}$ shown in Figure 1 and its peripheral member;

Figure 2B is a cross-section taken along the line B—B shown in Figure 2A;

Figure 2C is a circuit diagram of an equivalent circuit of the members shown in Figures 2A and complementary N-channel transistor $Q_{n2}$;

Figure 3A is a plan of a device in accordance with the present invention;

Figure 3B is a cross-section taken along a line B—B shown in Figure 3A;

Figure 3C is a circuit diagram of an equivalent circuit of the members shown in Figure 3A and a complementary N-channel transistor $Q_{n2}$;

Figure 4A is a circuit diagram of an equivalent circuit of a prior N-channel transistor $Q_{n1}$ and a P-channel transistor $Q_{p1}$ shown in Figure 1; and,

Figure 4B is a circuit diagram of the equivalent circuit of an N-channel transistor $Q_{n1}$ and the P-channel transistor $Q_{p1}$, in accordance with the present invention.

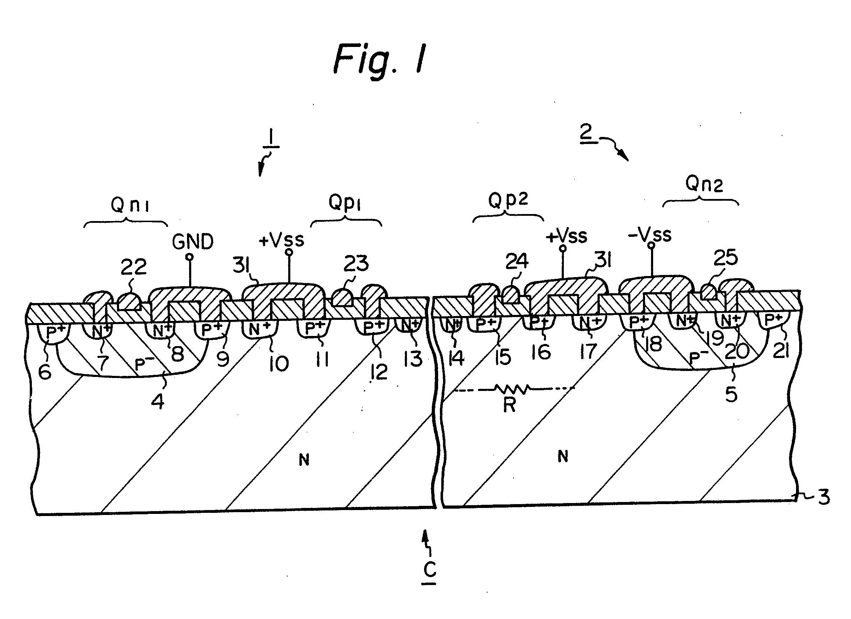

In the example shown in Figure 1, a single silicon chip C has both a digital circuit area 1 and an analogue circuit area 2 formed therein. The digital circuit area 1 includes a large number of CMOS elements, that is digital CMOS elements, while, the analogue circuit area 2 includes a large number of CMOS elements, that is analogue CMOS elements. However, in this Figure, only one digital CMOS element and also only one analogue CMOS element are illustrated. The digital CMOS element is formed by both an N-channel transistor $Q_{n1}$ and a P-channel transistor $Q_{p1}$. Also, the analogue CMOS element is formed by both an N-channel transistor $Q_{n2}$ and a P-channel transistor $Q_{p2}$. These transistors $Q_{n1}$, $Q_{p1}$, $Q_{n2}$ and $Q_{p2}$ are formed in and on a bulk, such as an N-type substrate 3. Especially, the transistors $Q_{n1}$ and $Q_{n2}$ are, respectively, formed in and on a bulk, such

as P⁻-well 4 and P⁻-well 5. The transistor $Q_{n1}$ is comprised of an N⁺-type drain region 7, an N⁺-type source region 8 and a gate electrode 22. The transistor $Q_{p1}$ is comprised of a P⁺-type source region 11 and a P⁺-type drain region 12 and a gate electrode 23. The transistor $Q_{p2}$ is comprised of a P⁺-type drain region 15, a P⁺-type source region 16 and a gate electrode 24. The transistor $Q_{n2}$ is comprised of an N⁺-type source region 19, an N⁺-type drain region 20 and a gate electrode 25.

The N-channel transistor $Q_{n1}$ is surrounded by P⁺-type diffusion regions 6 and 9. The P-channel transistor $Q_{p1}$ is surrounded by N⁺-type diffusion regions 10 and 13. Similarly, the P-channel transistor $Q_{p2}$ is surrounded by N⁺-type diffusion regions 14 and 17, and the N-channel transistor $Q_{n2}$ is surrounded by P⁺-type diffusion regions 18 and 21. These diffusion regions 6, 9, 10, 13, 14, 17, 18 and 21 are useful for suppressing the creation of a so-called latchup phenomenon. As shown, latchup phenomenon is derived from a so-called thyristor effect which is usually caused by both a parasitic NPN transistor and a parasitic PNP transistor, which are usually formed in a semiconductor device having a CMOS structure.

Further, in Fig. 1, each of the hatched areas on the substrate 3, in which hatching lines are inclined from the right at the top to the left at the bottom such as those indicated by reference numerals 22, 23, 24, 25 & 31, represents a conductor layer, such as aluminium. Each of the hatched areas on the substrate 3, in which closely spaced hatching lines are inclined from the left at the top to the right at the bottom, represents an insulation layer, such as silicon dioxide (SiO₂). It should be understood that a conventional protective layer, such as phospho-silicate glass (PSG), which covers the top surface of the CMOS device is not illustrated. Further, although the digital circuit area 1 is driven by the power sources +Vss and GND (ground), the analogue circuit area 2 is driven by the power sources +Vss and −Vss so as to produce a high analogue power.

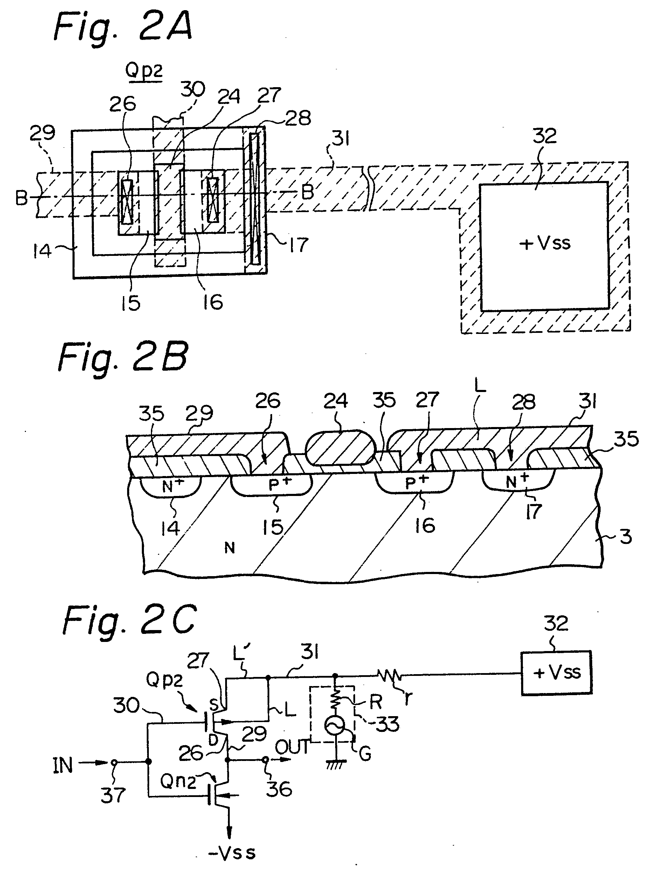

As previously mentioned, in a CMOS device having such a structure as shown in Fig. 1, undesired electric noise signals are induced in the analogue circuit area 2. The reason for this will be clarified with reference to Figs. 2A, 2B and 2C. Fig. 2A depicts a plan view of the P-channel transistor $Q_{p2}$ shown in Fig. 1 and its peripheral member. Fig. 2B is a cross-sectional view taken along a line B—B shown in Fig. 2A. Fig. 2C is an equivalent circuit diagram of members shown in Fig. 2A and an N-channel transistor $Q_{n2}$ shown in Fig. 1. In these Figures, the members, represented by the same reference numerals or symbols as those of Fig. 1, are identical with each other. Referring to Figs. 2A, 2B and 2C, a drain contact window 26 is formed in an insulation layer 35 and on the P⁺-type drain region 15. A source contact window 27 is formed in the insulation layer 35 and on the P⁺-type source region 16. A contact window 28 is formed in the insulation layer 35 and on the N⁺-type diffusion region 17. The region 17, together with the N⁺-type diffusion region 14 are useful, as previously explained, for suppressing the latchup phenomenon. That is, these regions are located in the neighbourhood of the transistor $Q_{p2}$ and apply a predetermined voltage, for example a voltage of a power source (+Vss), to the semiconductor substrate 3. Since the latchup phenomenon is commonly known by a person skilled in the art, details thereof are not mentioned. A drain conductor 29, such as aluminum, is distributed, via the window 26, between the P⁺-type drain region 15 and the transistor $Q_{n2}$, via an analogue output terminal 36. A gate conductor 30, such as aluminum or polysilicon, is connected, on one hand, to the gate electrode 24, and, on the other hand, to an analogue input terminal 37. A conductor 31 is distributed between the P⁺-type source region 16, via the source contact window 27, and a bonding pad 32 to which the voltage of said power source (+Vss) is applied (no power source is illustrated in any of the accompanying figures). In Fig. 2C, the symbol r represents a resistive component of the conductor 31. The symbol L represents an electrical connection between the P⁺-type source region 16 (Fig. 2B) and the N⁺-type diffusion region 17 (Fig. 2B). Accordingly, this connection L is the same as an area L shown in Fig. 2B. A reference numeral 33 schematically represents a source of electric noise signals.

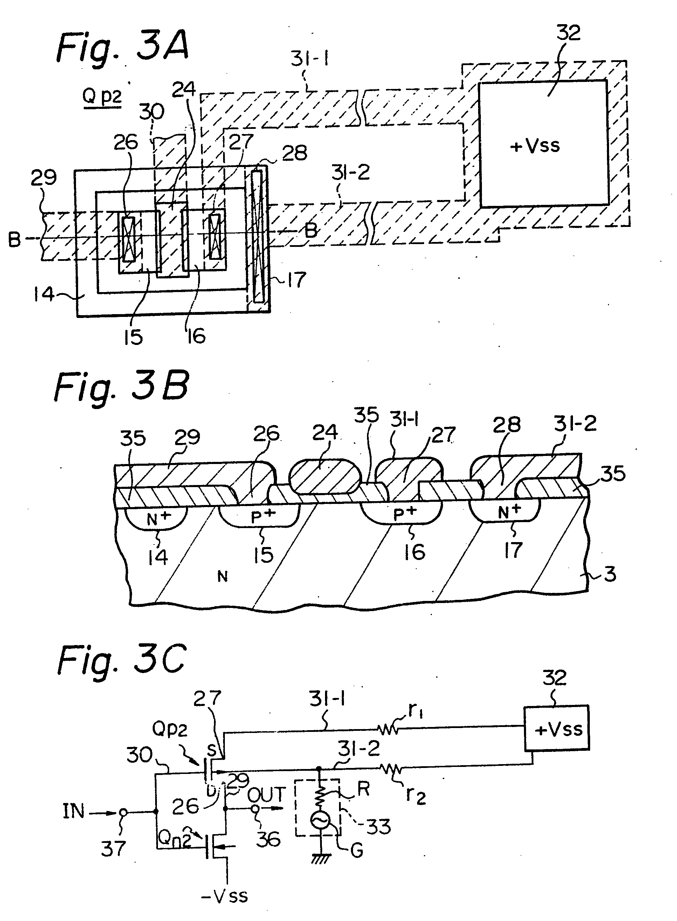

Details of the noise source 33 of Fig. 3A will be mentioned below. Returning to Fig. 1 again, when the P-channel transistor $Q_{p1}$ becomes ON and OFF (accordingly the N-channel transistor $Q_{n1}$ becomes OFF and ON), so as to create successive rectangular pulse signals, spike pulse currents are generated every time the falling edge of each of the rectangular pulse signals is produced. The spike pulse currents are supplied, from the power source (+Vss) (see the member 32 in Fig. 2A or 2C) to a stray capacity formed, in the substrate 3, at the junction of the transistor $Q_{p1}$ and $Q_{n1}$, on the one hand, via the conductor 31, which is substantially the same as the conductor 31 shown in Figs. 2A, 2B and 2C, and, on the other hand, via a path in the substrate 3. The path is schematically represented by a resistive component R. It should be noted that the resistive path R of Fig. 1 corresponds to a resistive path R of said noise source 33 shown in Fig. 2C. When said spike pulse currents flow through this resistive path R, a spike pulse voltage appears across the path R in synchronous with the occurrence of the spike pulse current. The spike pulse voltage is schematically illustrated as a voltage generator G in the noise source 33 in Fig. 2C.

Thus, the voltage generated by the voltage generator G is applied to the area, in the substrate 3, where the transistor $Q_{p2}$ is located. The inventors have already found that, through various kinds of experiments, the variation of the voltage appearing at a source region of a transistor, causes a much worse effect on this transistor, in view of the electric noise signal, than the variation of the voltage appearing in the substrate. Accordingly, in Fig. 2C, since the noise source 33 is connected not only to the substrate, close to the transistor $Q_{p2}$, via the connection L, but also to the source thereof, via an electric connection L', the noise source 33 causes a much worse effect, in view of the electric noise signal, to the transistor $Q_{p2}$.

Contrary to the above, in the present invention, the noise source 33 does not cause a bad effect on the transistor $Q_{p2}$. This is because the noise source 33 is not directly connected to the source of the transistor $Q_{p2}$, as apparent from Figs. 3A, 3B and 3C. Fig. 3A depicts a plan view of the P-channel transistor $Q_{p2}$ and its peripheral member, improved according to the present invention. Fig. 3B is a cross-sectional view taken along a line B—B shown in Fig. 3A. Fig. 3C is an equivalent circuit diagram of members shown in Fig. 3A and an N-channel transistor $Q_{n2}$ shown in Fig. 1. Referring to these figures, aforesaid conductor 31 is transformed into a first conductor 31-1 and a second conductor 31-2. The first and second conductors 31-1 and 31-2 are physically independent from each other. The symbols $r_1$ and $r_2$ represent resistive components of the first and second conductors 31-1 and 31-2, respectively. Since only the second conductor 31-2 is distributed between the $N^+$-type diffusion region 17 and the bonding pad (+Vss) 32, the aforesaid variation of the voltage appearing in the substrate is applied, not to the source contact window 27, but to the region 17. Accordingly, the noise source 33 is connected only to the conductor 31-2, so that the spike pulse voltage is not applied to the source of the transistor $Q_{p2}$. Consequently, the bad effect, in view of the electric noise signal, to the transistor $Q_{p2}$, is reduced. The function of the first conductor 31-1 is substantially the same as that of the above mentioned conventional conductor 31; however, the first conductor 31-1 does not transmit the undesired spike pulse voltage, as does the conductor 31.

In Fig. 3C, it is deemed that, although the undesired spike pulse voltage is not directly applied to the source of the transistor $Q_{p2}$, the undesired spike pulse voltage may be applied thereto via the conductor 31-2, the bonding pad 32 and the first conductor 31-1. However, the above mentioned fact is not true, because, all of the spike pulse voltage signals are absorbed in a capacitor having a large capacitance, which capacitor is usually contained in said power source connected to the bonding pad 32.

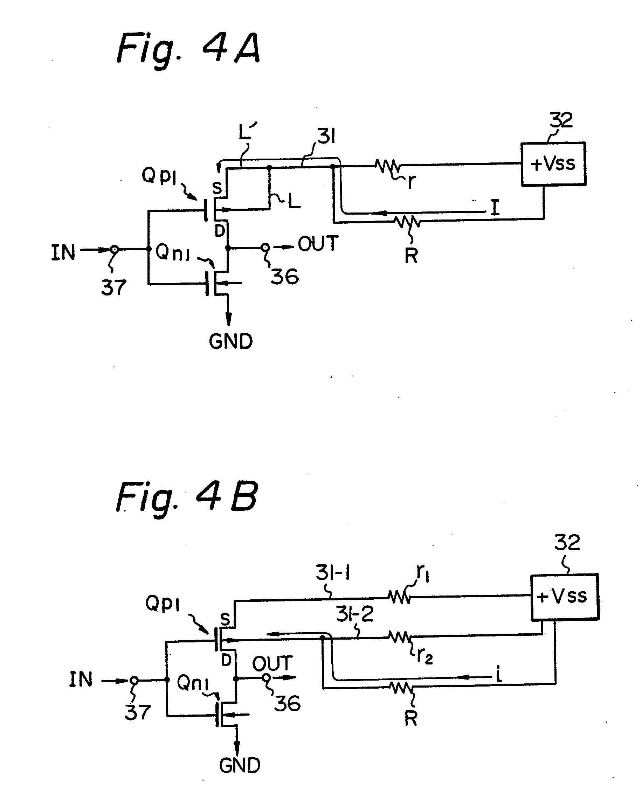

The first and second conductors 31-1 and 31-2 can also be employed in the CMOS element of the digital circuit area 1 (see Fig. 1). Fig. 4A is an equivalent circuit diagram of the N-channel transistor $Q_{n1}$ and the P-channel

transistor $Q_{p1}$ shown in Fig. 1, and Fig. 4B is an equivalent circuit diagram of the N-channel transistor $Q_{n1}$ and the P-channel transistor $Q_{p1}$, improved according to the present invention. In Figs. 4A and 4B, the members represented by the same reference numerals and symbols as those of Figs 2C and 3C, are functionally identical to each other. As previously mentioned, in Fig. 4A, said spike pulse currents flow, on one hand, via the conductor 31 and, on the other hand, via the resistive path R in the substrate, both from the bonding pad 32 which is common to both the digital circuit area 1 (Fig. 1) and the analogue circuit area 2 (Fig. 1). The resistive path R of Fig. 4A is identical to the resistive path R shown in Figs. 1, 2C and 3C. As seen from Fig. 4A, since the resistive path R is directly connected to the source of the transistor $Q_{p1}$ via the connection L', the magnitude of the aforesaid spike pulse current I is considerably large. Therefore, the aforesaid spike pulse voltage, across the resistive path R, is also considerably large, and accordingly the voltage generator G (see Figs. 2C and 3C) acts as a high power voltage generator. Consequently, the electric noise signal, induced in the analogue CMOS elements of the analogue circuit area 2 (Fig. 1) is very strong.

Contrary to the above, as seen from Figure 4B, since the conductor 31 of Figure 4A is divided into the first conductor 31-1 and the second conductor 31-2 the resistive path R is not directly connected to the source of the transistor $Q_{p1}$. Accordingly, the magnitude of the spike pulse current i can be considerably reduced. Thus, the voltage generator G does not act as a strong voltage generator, and therefore, the electric noise signal, induced in the analogue circuit area 2 (Figure 1) can be reduced to about zero.

The diffusion regions such as regions 6, 9, 10, 13, 14, 17, 18 and 21 adjacent the CMOS elements pick up the noise signals and when they are directly connected to the source regions of their adjacent CMOS elements the noise signal picked up, for example by regions 14 and 17, is applied directly to their source region, for example region 16, and so transferred directly to the adjacent CMOS element. By using separate, physically independent conductors to connect the regions such as regions 6, 9, 10, 13, 14, 17, 18 and 21 and the source regions 8, 11, 16, and 19 independently to the power supply terminals +$V_{ss}$, −$V_{ss}$, and GND the noise signals picked up by the regions 6, 9, 10, 13, 14, 17, 18 and 21 are not applied directly to the source regions 8, 11, 16 and 19 and the capacity of the conductors and the power supply terminals is sufficient to absorb the transient noise spikes and hence decouple the regions 6, 9, 10, 13, 14, 17, 18 and 21, from the sources 8, 11, 16 and 19 in spite of their interconnection via the power supply terminals +$V_{ss}$, −$V_{ss}$ and GND.

Thus, the first and second conductors 31-1, 31-2 may be employed not only in the analogue circuit area 2 (Figure 1), but also in the digital circuit area 1 (Figure 1). It is best to employ the first and second conductors 31-1, 31-2 in both the digital and analogue circuit areas, simultaneously.

Even through the above mentioned explanation is directed only to the P-channel transistor $Q_{p1}$ and/or the P-channel transistor $Q_{p2}$, it should be understood that first and second conductors, similar to the aforesaid first and second conductors 31-1, 31-2, can also be incorporated with the N-channel transistors $Q_{n1}$ and $Q_{n2}$.

As mentioned above, according to the present invention, a so-called noiseless CMOS device, which contains therein both digital and analogue CMOS elements, can be obtained.

## Claims

1. A semiconductor device comprising at least one digital CMOS (Complementary Metal Oxide Semiconductor) element having a source region (11) and a drain region (12) both formed in a bulk (3), and at least one analogue CMOS element having a source region (16) and a drain region (15) both formed in the bulk (3), the digital CMOS element having a diffusion region (10) adjacent it and the analogue CMOS element having a diffusion region (17) adjacent it, the diffusion regions also being formed in the bulk and being connected to power supply terminals ($V_{ss}$) which are also connected to the source regions (11, 16) of the corresponding elements characterised in that the device includes at least one first conductor (31-1) and second conductor (31-2) which are physically independent of each other, the first conductor (31-1) being connected between the power supply terminal ($V_{ss}$) and one of the source regions (16, 11), and the second conductor (31-2) being connected between the power supply terminal ($V_{ss}$) and the diffusion region (17, 10) of the corresponding element.

2. A device according to Claim 1, wherein the bulk is formed as the semiconductor substrate (3) on which the semiconductor device is fabricated.

3. A device according to Claim 1, wherein the bulk is formed as a well (4, 5) contained in a semiconductor substrate (3) on which the semiconductor device is fabricated.

4. A device according to any one of the preceding claims, further characterised in that the first (31-1) and second conductors (31-2) are used only in the analogue CMOS element or elements.

5. A device according to any one of Claims 1 to 3, further characterised in that the first (31-1) and second (31-2) conductors are used only in the digital CMOS element or elements.

6. A device according to any one of Claims 1 to 3, further characterised in that the first (31-1) and second (31-2) conductors are used in all of the digital and analogue CMOS elements.

7. A semiconductor device comprising at least one digital CMOS (Complementary Metal Oxide Semiconductor) element, having a source region (11) and a drain region (12) both formed in a bulk, and at least one analogue CMOS element having a source region (16) and a drain region (15) both formed in the bulk, the digital CMOS element having a diffusion region (10) adjacent it, and the analogue CMOS element having a diffusion region (17) adjacent it, the diffusion regions (10, 17) also being formed in the bulk and connected to power supply terminals ($V_{ss}$) which are also connected to the source regions (16, 11) of the corresponding elements, characterised in that each of the source regions (16, 11) is not directly connected to the diffusion region (17, 10) adjacent it and that its connection to the diffusion region adjacent it via the common power supply terminal has sufficient capacitance to decouple the source region from its adjacent diffusion region so that noise picked up by the diffusion region (17, 10) is not transferred to the source region (16, 11).

## Patentansprüche

1. Halbleitervorrichtung mit wenigstens einem digitalen CMOS-Element (Complementary Metal Oxide Semiconductor Element), welches einen Sourcebereich (11) und einen Drainbereich (12) aufweist, die beide in einem Grundmaterial (3) ausgebildet sind, und wenigstens einem analogen CMOS-Element, welches in dem Grundmaterial (3) ausgebildet einen Sourcebereich (16) und einen Drainbereich (15) aufweist, wobei das digitale CMOS-Element einen benachbarten Diffusionsbereich (10) und das analoge CMOS-Element einen benachbarten Diffusionsbereich (17) aufweisen und die Diffusionsbereiche ebenfalls in dem Grundmaterial ausgebildet und mit den Stromversorgungsanschlüssen ($V_{ss}$) verbunden sind, welche auch mit den Sourcebereichen (11, 16) der entsprechenden Elemente verbunden sind, dadurch gekennzeichnet, daß die Vorrichtung wenigstens einen ersten Leiter (31-1) und einen zweiten Leiter (31-2) aufweist, welche physisch voneinander unabhängig sind, von denen der erste Leiter (31-1) zwischen dem Stromversorgungsanschluß ($V_{ss}$) und einem der Sourcebereiche (16, 11) und der zweite Leiter (31-2) zwischen dem Stromversorgungsanschluß ($V_{ss}$) und dem Diffusionsbereich (17, 10) des entsprechenden Elements angeschlossen ist.

2. Halbleitervorrichtung nach Anspruch 1, bei welchem das Grundmaterial als Halbleitersubstrat (3) ausgebildet ist, auf welchem die Halbleitervorrichtung hergestellt ist.

3. Vorrichtung nach Anspruch 1, bei welcher das Grundmaterial als Vertiefung (4, 5) in einem Halbleitersubstrat (3) ausgebildet ist, auf welchem die Halbleitervorrichtung hergestellt ist.

4. Vorrichtung nach einem der vorhergehenden Ansprüche, dadurch gekennzeichnet, daß der erste Leiter (31-1) und der zweite Leiter (31-2) nur in den analogen CMOS-Element oder -Elementen verwendet ist.

5. Vorrichtung nach einem der Ansprüche 1 bis 3, dadurch gekennzeichnet, daß der erste Leiter (31-1) und der zweite Leiter (31-2) nur in dem digitalen CMOS-Element oder -Elementen verwendet ist.

6. Vorrichting nach einem der Ansprüche 1 bis 3, dadurch gekennzeichnet, daß der erste Leiter (31-1) und der zweite Leiter (31-2) in allen digitalen und analogen CMOS-Elementen verwendet sind.

7. Halbleitervorrichtung mit wenigstens einem digitalen CMOS-Element (Complementary Metal Oxide Semiconductor Element), welches in einem Grundmaterial ausgebildet einen Sourcebereich (16) und einen Drainbereich (15) aufweist, und mit wenigsten einem analogen CMOS-Element, welches in dem Grundmaterial ausgebildet einen Sourcebereich (16) und einen Drainbereich (15) aufweist, wobei das digitale CMOS-Element einen benachbarten Diffusionsbereich (10) und das analoge CMOS-Element einen benachbarten Diffusionsbereich (17) aufweisen und die Diffusionsbereiche (10, 17) ebenfalls in dem Grundmaterial ausgebildet und mit den Stromversorgungsanschlüssen ($V_{SS}$) verbunden sind, welche auch mit den Sourcebereichen (16, 11) der entsprechenden Elemente verbunden sind, dadurch gekennzeichnet, daß jeder der Sourcebereiche nicht direkt mit dem ihm benachbarten Diffusionsbereich (17, 10) verbunden ist und daß seine Verbindung mit dem ihm benachbarten Diffusionsbereich über den gemeinsamen Stromversorgungsanschluß eine hinreichende Kapazität hat, um den Sourcebereich von dem ihm benachbarten Diffusionsbereich zu entkoppeln, so daß von dem Diffusionsbereich (17, 10) aufgenommenes Rauschen nicht zu dem Sourcebereich (16, 17) übertragen wird.

**Revendications**

1. Dispositif semi-conducteur comprenant au moins un élément CMOS (métal-oxyde-semi-conducteur complémentaire) numérique possédant une région de source (11) et une région de drain (12) toutes deux formées dans le volume (3), et au moins un élément CMOS analogique possédant une région de source (16) et une région de drain (15) toutes deux formées dans le volume (3), l'élément CMOS numérique possédant une région de diffusion (10) en son voisinage et l'élément CMOS analogique possédant une région de diffusion (17) dans son voisinage, les régions de diffusion étant également formées dans le volume et étant connectées à des bornes d'alimentation

électrique ($V_{ss}$) qui sont également connectées aux régions de source (11, 16) des éléments correspondants, caractérisé en ce qu'il comporte au moins un premier conducteur (31-1) et un deuxième conducteur (31-2) qui sont matériellement indépendant l'un de l'autre, le premier conducteur (31-1) étant connecté entre la borne d'alimentation électrique ($V_{ss}$) et une des régions de source (16, 11), et le deuxième conducteur (31-2) étant connectés entre la borne d'alimentation électrique ($V_{ss}$) et la région de diffusion (17, 10 de l'élément correspondant.

2. Dispositif selon la revendication 1, où le volume est formé par le substrat semi-conducteur (3) sur lequel le dispositif semi-conducteur est fabriqué.

3. Dispositif selon la revendication 1, où le volume est formé par un puits (4, 5) contenu dans un substrat semi-conducteur (3) sur lequel le dispositif semiconducteur est fabriqué.

4. Dispositif selon l'une quelconque des revendications précédentes, caractérisé en outre en ce que le premier conducteur (31-1) et le deuxième conducteur (31-2) ne sont utilisés que dans l'élément ou les éléments CMOS analogiques.

5. Dispositif selon l'une quelconque des revendications 1 à 3, caractérisé en outre en ce que le premier conducteur (31-1) et le deuxième conducteur (31-2) ne sont utilisés que dans l'élément ou les éléments CMOS numériques.

6. Dispositif selon l'une quelconque des revendications 1 à 3, caractérisé en outre en ce que le premier conducteur (31-1) et le deuxième conducteur (31-2) sont utilisés dans tous les éléments CMOS numériques et analogiques.

7. Dispositif semi-conducteur comprenant au moins un élément CMOS (métal-oxyde-semi-conducteur complémentaire) numérique possédant une région de source (11) et une région de drain (12) toutes deux formées dans le volume, et au moins un élément CMOS analogique possédant une région de source (16) et une région de drain (15) toutes deux formées dans le volume, l'élément CMOS numérique possédant une région de diffusion (10) dans son voisinage, et l'élément CMOS analogique possédant une région de diffusion (17) dans son voisinage, les régions de diffusion (10, 17) étant également formées dans le volume et étant connectées à des bornes d'alimentation électrique ($V_{ss}$) qui sont également connectées aux régions de source (16, 11) des éléments correspondant, caractérisé en ce que chacune des régions de source (16, 11) n'est pas directement connectée à la région de diffusion (17, 10) située en son voisinage et en ce que sa connexion avec la région de diffusion située en son voisinage via la borne d'alimentation électrique commune possède une capacité suffisante pour découpler la région de source vis-à- vis de sa région de diffusion adjacente, si bien que le bruit capté par la région de diffusion (17, 10) n'est pas transféré à la région de source (16, 11).

Fig. 1

*Fig. 2A*

*Fig. 2B*

*Fig. 2C*

## Fig. 3A

Qp2

29

B —— —— B

14  15  16  17

26  30  24  27  28

31-1  31-2  32

+Vss

## Fig. 3B

35  29  26  24  35  31-1  27  28  31-2  35

N+  P+  P+  N+

14  15  16  17

N  3

## Fig. 3C

27  31-1  r₁  32

Qp2  +Vss

30  s

31-2

29  R

IN →  26  OUT →  33

37  D  36  G

Qn2  r₂

−Vss

# Fig. 4 A

# Fig. 4 B